# EUROPÄISCHE PATENTSCHRIFT

(11) **EP 3 503 211 B1**
(45) Veröffentlichungstag und Bekanntmachung des Hinweises auf die Patenterteilung: **22.03.2023**
(21) Anmeldenummer: 17209638.0
(22) Anmeldetag: 21.12.2017
(51) Int. Cl.: H01L 31/0352

(54) **HALBLEITER-BAUELEMENT MIT EINEM HOCHDOTIERTEN QUANTENSTRUKTUR-EMITTER**
SEMICONDUCTOR ELEMENT WITH HIGHLY DOSED QUANTUM STRUCTURE EMITTER
COMPOSANT SEMI-CONDUCTEUR POURVU D'ÉMETTEUR À STRUCTURE QUANTIQUE FORTEMENT DOPÉ

(43) Veröffentlichungstag der Anmeldung: 26.06.2019
(73) Patentinhaber: AE 111 Autarke Energie GmbH, 9556 Liebenfels (AT)
(72) Erfinder: Schüppen, Andreas Paul, 8020 Graz (AT); Stowasser, Rainer, 8075 Hart bei Graz (AT)
(74) Vertreter: Epping - Hermann - Fischer

(56) Entgegenhaltungen:
- EP-A1- 2 469 608
- DE-A1-102005 047 221
- US-A- 5 059 545
- US-A1- 2005 056 827

## Beschreibung

Es wird ein Halbleiter-Bauelement, das eine Solarzelle ist, mit einem hochdotierten Quantenstruktur-Emitter angegeben.

Silizium-Solarzellen werden kommerziell im großen Stil erst seit Anfang dieses Jahrtausends produziert und vermarktet. Es gibt zurzeit vor allem folgende wichtige Technologien mit folgenden Leistungseffizienzen:
Weltrekorde:
   Crystalline III-V, 44,7 %
   Thin Film a-Si/c-Si, 20,8 %
   Thin Film CIGS, 20,5 %
   Thin Film CdTe, 21,0 %
   Crystalline Silicon, 25,6 %
Produktion:
   Crystalline III-V, 25 %
   Thin Film a-Si, 19 %
   Thin Film CIGS, 10 % bis 13 %
Solarzellen, basierend auf kristallinem Silizium:
   Standard Silicon, 18 % bis 19 %
   PERC, 20 % bis 21 %
   HJT, 23 % bis 25 %
   IBC des Herstellers Sunpower, 24 % bis 25 %

Dabei steht CIGS für Kupfer-Indium-Gallium-Diselenid. PERC steht für Passivated Emitter Rear Cell, wobei der Wirkungsgrad der Solarzelle durch eine Passivierung der Rückseite erhöht wird, sodass Licht, welches die Rückseite erreicht, ohne freie Ladungsträger produziert zu haben, zurück in die Zelle reflektiert wird. HJT bezeichnet Heterojunction-Technologie, also Solarzellen mit mehreren Ladungsträgererzeugungsbereichen. IBC bedeutet Interdigited Back Contact, wobei alle elektrischen Kontakte auf einer Rückseite der Zelle liegen, sodass eine Abschattung durch eine vorderseitige Kontaktfingerstruktur verhindert wird.

Zur Zeit gibt es keine Produktionstechnologie für terrestrische Anwendungen, die kosteneffizient 23 % Wirkungsgrad übersteigt. Auch ist es bei herkömmlichen Solarzellen so, dass der reale Leistungswirkungsgrad bei einer Temperatur von etwa 85 °C auf ungefähr die Hälfte abgefallen ist. Dadurch ist der Einsatz von herkömmlichen Solarzellen insbesondere in Wüstenregionen stark eingeschränkt.

Bifaciale Solarzellen, die auch das rückwärtige Streulicht nutzen, haben hier eine Verbesserung gebracht. Jedoch lösen sie das Problem des Temperaturkoeffizienten, kurz TK, von Silizium-Solarzellen nicht. Ein vielversprechender Ansatzpunkt sind die HJT- und PERC-Zellen, die vor allem in neu installierten Solarfabriken produziert werden und einkristallines Silizium mit amorphem Silizium vor allem für die Kontaktbereiche kombinieren. Auch bei diesen Zellen werden im Labor nur Wirkungsgrade von unter 25 % erreicht, und Leistungs-TK können auch durch diese Zellarten nicht wesentlich reduziert werden.

Die Druckschrift US 5 059 545 A offenbart einen Quantenemitter, der auf InAlGaAs oder InAlGaP basiert.

Die Druckschrift DE 10 2005 047 221 A1 betrifft eine Doppelhetero-Tunneltransistor-Schichtfolge aus Silizium-Germanium-Kohlenstoff und ein Verfahren zu deren Herstellung. Es wird eine Schichtfolge aus fünf Schichten vorgeschlagen. Dabei wird die Schichtfolge vorzugsweise mittels eines CVD-Verfahrens abgeschieden und mittels Kurzzeittemperung nachbehandelt. Es wird erwartet, dass eine solche Transistorstruktur Grenzfrequenzen im Terahertz-Bereich besitzen wird.

In der Druckschrift US 2015/0056827 A1 finden sich Tunneldioden, basierend auf dem SiGe-Materialsystem.

Aus der Druckschrift EP 2 469 608 A1 ist eine Siliziumbasierte, einstufige Solarzelle bekannt, die anstelle der Lichtumwandlung im inneren eines aus der Schmelze gezogenen Halbleitermaterials die Stromerzeugung innerhalb einer sehr dünnen, aufgebrachten Quantenstruktur nutzt. Dabei besteht die Schichtfolge selbst als aktiver Absorber aus einer dreifachen Heterostruktur, die in die Raumladungszone eines pn-Übergangs eingebettet ist und quantenmechanische Effekte nutzt.

Eine zu lösende Aufgabe liegt darin, ein Halbleiter-Bauelement wie eine Solarzelle anzugeben, das einen hohen Wirkungsgrad und einen reduzierten Temperaturkoeffizienten aufweist.

Diese Aufgabe wird durch ein Halbleiter-Bauelement mit den Merkmalen des Anspruchs 1 gelöst. Bevorzugte Weiterbildungen sind Gegenstand der übrigen Ansprüche.

Insbesondere liegt ein Ziel der vorliegenden Patentanmeldung darin, den Wirkungsgrad von Silizium-basierten Solarzellen auf über 30 % zu erhöhen und den Temperaturkoeffizienten der Leistungseffizienz von Modulen von derzeit etwa -0,4 %/K mehr als zu halbieren. Daraus ergibt sich insbesondere auch die Aufgabe, eine offene Klemmenspannung, kurz Voc, und/oder einen Kurzschlussstrom, kurz Isc, deutlich zu erhöhen. Aufgrund des positiven Temperaturkoeffizienten des Isc ist es vor allem sinnvoll, den Strom zu erhöhen und nicht nur die Spannung der Zelle.

Ein weiterer Aspekt der vorliegenden Patentanmeldung ist es, die vorgeschlagene Solarzelle mit bekannten Techniken und kostengünstig herstellen zu können.

Es kann durch eine Erhöhung der offenen Klemmenspannung Voc der nutzbare Spannungsbereich erhöht werden. Hierzu kann zum Beispiel Alpha-Silizium in eine Raumladungszone eingebracht werden, wie dies in HJT-Zellen versucht wird. Hierbei wurden Voc-Werte bis hin zu 0,74 V erreicht. Da jedoch der TK vor allem durch die Bandabstandsreduktion bei Temperaturerhöhung bestimmt wird, ist dies keine Lösung, um den TK zu reduzieren.

Dies kann insbesondere dadurch erreicht werden, dass in den Emitter und/oder Kollektor oder auch in den Übergang dieser beiden Zonen eine Quantenstruktur eingebettet wird, die den Temperaturkoeffizienten TK reduziert und gleichzeitig den Strom erhöht. Dabei wird der TK verkleinert durch die Einführung einer Quantenstruktur, die aus zwei Tunnelbarrieren und einem Quantental besteht. Durch einfallendes Licht werden Elektron-Loch-Paare vor allem im Quantental, das insbesondere aus SiGe besteht, erzeugt, und durch das elektrische Feld, welches durch den pn-Übergang entsteht, zu den Kontakten bewegt. Da in dem Quantental sogenannte Mini-Bänder oder Subbänder durch die angrenzenden Tunnelbarrieren entstehen, ist die Reduktion des Bandabstands durch Temperaturerhöhung nach außen kaum spürbar. Der Tunneleffekt ist darüber hinaus temperaturunabhängig.

Die hier vorgeschlagene Zelle hat daher einen hoch dotierten Emitter, der aus einer Quantenstruktur aus Silizium-Germanium, also SiₓGe₁₋ₓ, und Kohlenstoff C besteht. Dies hat den Vorteil, dass die Lichtabsorption für alle Wellenlängen mindestens um einen Faktor 100 größer ist als dies für reines Silizium der Fall wäre, wobei typischerweise x ≤ 0,8 gilt, was einem Germaniumanteil von größer als 20 % entspricht. Je höher der Germaniumanteil ist, umso größer ist die Absorption. Die Dicke der Silizium-Germaniumschicht ist limitiert durch die Ausbildung von sogenannten Subbändern und sollte demnach unter 12 nm liegen.

Erfindungsgemäß umfasst das Halbleiter-Bauelement, das eine Solarzelle ist, mindestens einen Quantenstruktur-Emitter. Der Quantenstruktur-Emitter umfasst eine erste Schicht aus einem undotierten Halbleitermaterial mit großem Bandabstand, eine zweite, mittlere, hoch dotierte Schicht aus einem Halbleitermaterial mit niedrigem Bandabstand und eine dritte, undotierte Schicht aus einem Halbleitermaterial mit großem Bandabstand. Der Quantenstruktur-Emitter besteht aus diesen drei Schichten.

Gemäß der vorliegenden Erfindung liegt der Bandabstand der ersten und/oder der dritten Schicht bei mindestens 1,5 eV, bevorzugt bei mindestens 2 eV. Aufgrund des hohen Bandabstands können die erste und die dritte Schicht auch als Barriereschichten des Quantenstruktur-Emitters aufgefasst werden.

Gemäß der vorliegenden Erfindung liegt der Bandabstand der zweiten Schicht bei höchstens 0,9 eV, bevorzugt bei höchstens 0,66 eV. Zusätzlich liegt eine Dotierstoffkonzentration der zweiten Schicht bei mindestens 5 × 10¹⁸ 1/cm³, bevorzugt bei mindestens 1 × 10¹⁹ 1/cm³. Aufgrund des kleinen Bandabstands kann die zweite Schicht auch als Emitterschicht oder Quantentopfschicht des Quantenstruktur-Emitters aufgefasst werden.

Gemäß zumindest einer Ausführungsform erfüllen die zumindest drei Schichten des Quantenstruktur-Emitters jeweils die Tunnelbedingungen. Das heißt zum Beispiel, dass ein Ladungsträger wie ein Elektron eine Potentialbarriere, die durch die Schichten verursacht ist, auch dann überwinden kann, wenn seine Energie geringer als die Höhe der Barriere aufgrund der Schichten ist. Beispielsweise heißt dies, dass die Schichten je eine Dicke von höchstens 10 nm, bevorzugt von höchstens 7 nm aufweisen. Eine Mindestdicke dieser Schichten liegt bei einer Monolage, bevorzugt bei mindestens 1 nm.

Gemäß zumindest einer Ausführungsform liegt eine Gesamtdicke des Quantenstruktur-Emitters bei höchstens 15 nm, bevorzugt bei höchstens 10 nm. Hierdurch ist es möglich, dass der Quantenstruktur-Emitter insgesamt die Tunnelbedingungen erfüllt.

Gemäß zumindest einer Ausführungsform ist die zweite Schicht bis zur Entartung dotiert. Dies bedeutet insbesondere, dass das Valenzband wie in einem Metall oberhalb des Fermi-Niveaus liegt.

Erfindungsgemäß bestehen die erste und die dritte Schicht aus SiGeC.

Gemäß einer Ausführungsform, welche nicht Teil der vorliegenden Erfindung ist, sind die erste und dritte Schicht des Quantenstruktur-Emitters aus (Si, Ge)_{1-z}C_{z}. Dabei gilt 0,05 ≤ z ≤ 0,5, wobei eventuell vorhandene Dotierungen vernachlässigt sind. Es kann sich der Ausdruck (Si, Ge)_{1-z}C_{z} auf eine mittlere Zusammensetzung über die betreffende Schicht hinweg beziehen.

Erfindungsgemäß bildet der Quantenstruktur-Emitter zumindest einen Teil einer ersten Diode. Zum Beispiel ist die erste Diode aus dem Quantenstruktur-Emitter, einem Wafer und einer entgegengesetzt dotierten Schicht zusammengesetzt.

Erfindungsgemäß umfasst das Halbleiter-Bauteil eine zweite Diode (n)_{.} Die zweite Diode kann der ersten Diode vorangestellt sein oder dieser nachfolgen.

Die zweite Diode ist aus einem anderen Halbleitermaterial als die erste Diode. Die zweite Diode weist einen größeren Bandabstand auf. Damit kann die zweite Diode zur Umwandlung von kurzwelligerer Strahlung in Ladungsträger eingerichtet sein, wohingegen die erste Diode zur Umwandlung von langwelligerer Strahlung in Ladungsträger dient.

Gemäß zumindest einer Ausführungsform sind zumindest die Schichten des Quantenstruktur-Emitters mittels eines CVD-Verfahrens, eines PECVD-Verfahrens, eines ALD-Verfahrens und/oder eines MBE-Verfahrens oder eines ähnlichen Verfahrens hergestellt. Dabei steht CVD für Chemical Vapour Deposition, PECVD für Plasma Enhanced Chemical Vapour Deposition, ALD für Atomic Layer Deposition und MBE für Molecular Beam Epitaxy.

Gemäß zumindest einer Ausführungsform sind die Schichten des Quantenstruktur-Emitters und/oder Schichten der zweiten Diode einkristallin, polykristallin oder amorph abgeschieden.

Gemäß zumindest einer Ausführungsform erstrecken sich die Schichten des Quantenstruktur-Emitters und/oder der zweiten Diode flächig und/oder zusammenhängend über den Quantenstruktur-Emitter und/oder über das Halbleiter-Bauelement. Das heißt, die genannten Schichten können sich mit einer gleichbleibenden Schichtdicke in unveränderter Materialzusammensetzung über das gesamte Bauteil, insbesondere über eine gesamte Lichtsammelfläche des Bauteils, erstrecken.

Nachfolgend wird ein hier beschriebenes Halbleiter-Bauelement unter Bezugnahme auf die Zeichnung näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figur 1: eine schematische Schnittdarstellung eines Teils des erfindungsgemäßen Halbleiter-Bauelements,
- Figur 3: eine schematische Schnittdarstellung des erfindungsgemäßen Halbleiter-Bauelements, und

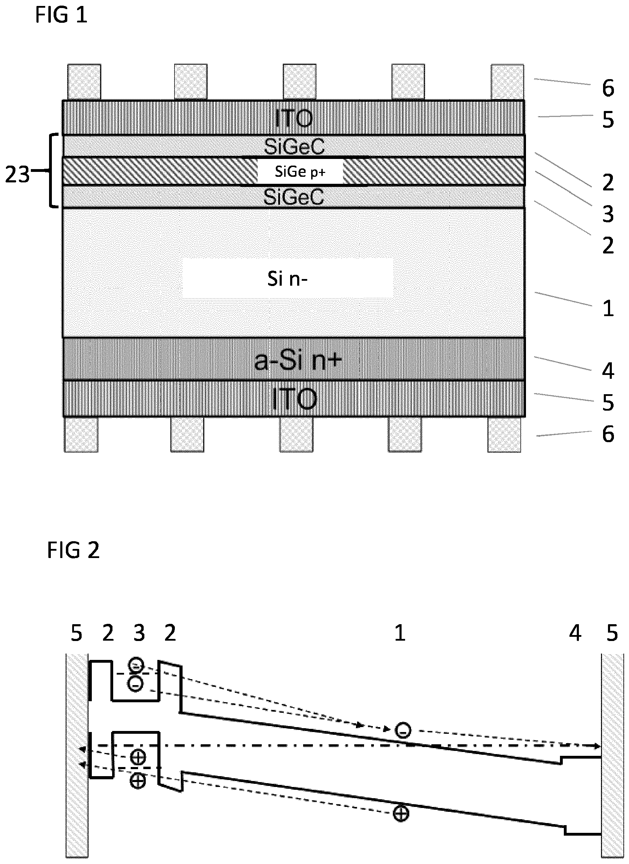

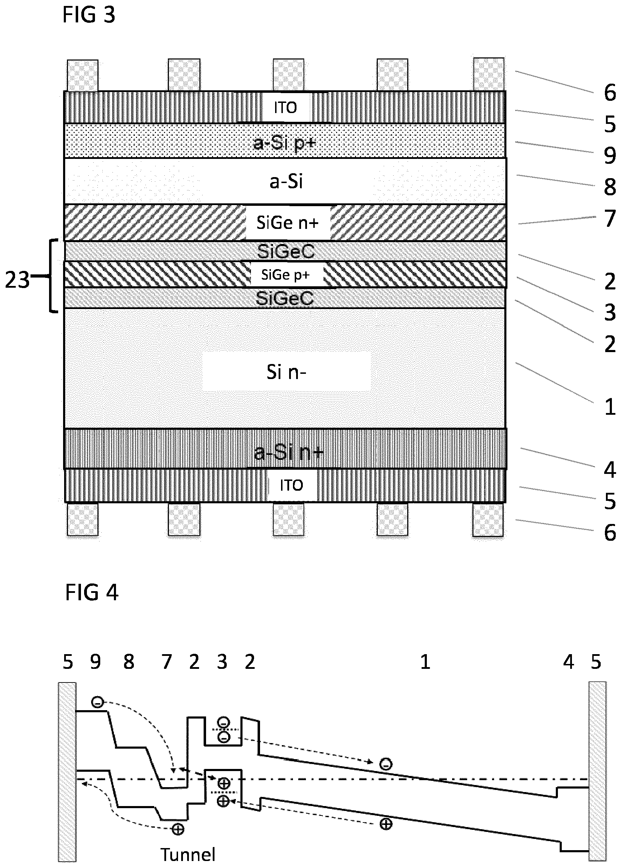

- Figuren 2 und 4: schematische Darstellungen der Bandstrukturen der Halbleiter-Bauelemente der Figuren 1 und 3.

In den Figuren 1 und 2 ist ein Halbleiter-Bauelement 10 in Form einer einstufigen Solarzelle mit hoch dotiertem Emitter aus einer SiGe-Quantenstruktur dargestellt. Dabei beschreibt Figur 1 den Schichtaufbau und Figur 2 die elektrische Bandstruktur.

Ausgehend von einem niedrig dotierten 1-2 **Ω**·cm n-Typ PV-Wafer 1 befindet sich an einer Oberseite ein Quantenstruktur-Emitter 23 bestehend aus einer dreifachen Schicht 2, 3, 2. Dabei sind die beiden äußeren Schichten 2 je eine Schicht aus SiGeC. Diese Schichten 2 zeichnen sich vor allem dadurch aus, dass sie einen deutlich höheren Bandabstand als Si aufweisen. Bei Si liegt der Bandabstand bei ungefähr 1,1 eV, wohingegen der Bandabstand der Schichten 2, wie in Figur 2 dargestellt, typischerweise zwischen 2 eV und 3,4 eV liegt.

Nicht erfindungsgemäß ist auch, dass diese Schichten 2 zum Beispiel aus SiO₂ oder Al₂O₃ gebildet sind, um sogenannte Tunnelbarrieren auszubilden. Diese Funktion bestimmt auch die Dicke der Schichten 2, die besonders bevorzugt unter 10 nm liegt, um den Tunneleffekt spürbar zu erzielen. Typischerweise liegt die Dicke dieser Schichten 2 zwischen einer Atom-Monolage und 7 nm.

Die mittlere Schicht 3 besteht aus einem Material mit niedrigerem Bandabstand, zum Beispiel aus Si, Ge oder SiGe. Nicht erfindungsgemäß sind auch III-V Halbleitermaterialien für diese Schicht 3 möglich, wie InP oder GaInP. Der Vorteil des hier verwendeten SiGe liegt darin, dass Ge einen wesentlich höheren Absorptionskoeffizienten besitzt als Si.

Die mittlere Schicht 3 hat gleichzeitig zwei Funktionen. Zum einen soll sie aufgrund ihrer Lage ein Quantental ausbilden und zum anderen soll sie als Emitter der vorgeschlagenen Solarzelle dienen. Die Lage zwischen den beiden Tunnelbarrieren 2 mit großem Bandabstand führt dazu, dass sich in dem Quantental Mini- bzw. Subbänder ausbilden. Dadurch können auch kurzwellige Photonen in Elektron-Loch-Paare umgewandelt werden. Auch kann man davon ausgehen, dass Mehrelektroneneffekte auftreten, die nach außen hin zu einer Stromerhöhung gegenüber herkömmlichen Solarzellen führen. Darum ist diese mittlere Schicht 3 hochdotiert, zum Beispiel wie hier dargestellt mit Bor, und damit einen Löcher leitenden Bereich ausbildend. Die Dotierung sollte über der Entartung liegen, das heißt, die Dotierung muss so hoch sein, dass das Valenzband E_{V} - untere dicke Linie in den Figuren 2 und 4 - wie in einem Metall oberhalb des Fermi-Niveaus E_{F -} gestrichelte Linie in den Figuren 2 und 4 - liegt.

Erfindungsgemäß liegt die p-Typ-Dotierung der mittleren Schicht 3 im Falle von SiGe mit 20 % bis 50 % Ge bei 8 - 20 × 10¹⁸ 1/cm³. Die Emitterschicht 3 dient dabei als Kontaktschicht.

Auf die Emitterschicht 3 kann zum Beispiel ein transparentes leitfähiges Oxid, kurz TCO, als elektrisch leitfähige Schicht 5 aufgebracht werden. Dieses kann zum Beispiel Indium-ZinnOxid, kurz ITO, sein. Die Rückseite der Solarzelle besteht aus einer hochdotierten Schicht 4, hier vom n-Typ, die bevorzugt ebenfalls bis über die Entartung hinaus dotiert ist. Für Si ist dies oberhalb von 2 × 10¹⁹ 1/cm³ der Fall. Dabei kann die Schicht einkristallin, polykristallin oder sogar amorph ausgebildet sein.

Bei den in den Figuren 1 und 3 dargestellten Solarzellen sind die Lichteintrittsflächen oben, was in den Figuren 2 und 4 jeweils links entspricht. Elektrische Kontaktstrukturen 6 sind beispielsweise Silberfinger, die als Stromabgriff dienen, das heißt, die den in der Solarzelle erzeugten Strom niederohmig abführen sollen. Diese Finger 6 können auch ohne Weiteres aus einem anderen Metall mit hoher elektrischer Leitfähigkeit, wie Kupfer, gebildet sein.

Die in den Figuren 1 und 2 dargestellte Solarzelle hat den Vorteil, dass sie sowohl einfach herzustellen ist als auch einen größeren Kurzschlussstrom Isc liefert als herkömmliche Solarzellen. Jedoch wird im Regelfall keine signifikant höhere offene Klemmenspannung Voc geliefert. Dies liegt etwa daran, dass die offene Klemmenspannung Voc auch durch den Bandabstand der verwendeten Materialien bestimmt wird, die bei Ge-Gehalten von 20 % bis 50 % in der Emitterschicht 3 bei 0,7 eV bis 1 eV liegen wird.

Daher wird die einstufige Solarzelle der Figuren 1 und 2 erfindungsgemäß zu einer zweistufigen Tandemzelle erweitert, wie dies in den Figuren 3 und 4 dargestellt ist. Dabei kann von dem Schichtaufbau von der oben beschriebenen Schichtstruktur in Figur 1 ausgegangen werden. Diese wird um die Schichten 7, 8, 9 erweitert.

Dabei bilden diese Halbleiterschichten 7, 8, 9 eine zweite Diode mit einem höheren Bandabstand aus. Hierbei bilden die Schichten 3, 7 einen Band-zu-Band-Tunnelkontakt aus, um die beiden Zellen elektrisch in Reihe zu schalten. Dieser Kontakt ist in SiGe mit einem Germaniumanteil über 30 % ausgelegt, um die Tunnelwahrscheinlichkeit zu erhöhen. Die erste Schicht 7 ist zum Beispiel mit As über 2 × 10¹⁹ 1/cm³ dotiert und bevorzugt zwischen einschließlich 20 nm und 80 nm dick.

Es folgt als zweite Halbleiterschicht 8 bevorzugt eine intrinsische, amorphe Si-Schicht, zum Beispiel mit einer Dicke zwischen 10 nm und 40 nm, insbesondere um 20 nm. Als Kontaktschicht 9 dient insbesondere eine hoch dotierte a-Si Schicht, ebenfalls um die 20 nm dick, zum Beispiel mindestens 10 nm und höchstens 40 nm. Die Kontakte 5, 6 oben und unten werden, wie in Figur 1, bevorzugt je aus einer TCO-Schicht 5 und einem Metallgitter 6 gebildet.

Die in den Figuren gezeigten Komponenten folgen, sofern nicht anders kenntlich gemacht, bevorzugt in der angegebenen Reihenfolge jeweils unmittelbar aufeinander. Sich in den Figuren nicht berührende Schichten sind bevorzugt voneinander beabstandet. Soweit Linien parallel zueinander gezeichnet sind, sind die entsprechenden Flächen bevorzugt ebenso parallel zueinander ausgerichtet. Ebenfalls, soweit nicht anders kenntlich gemacht, sind die relativen Positionen der gezeichneten Komponenten zueinander in den Figuren korrekt wiedergegeben.

### Bezugszeichenliste

- 1: Wafer
- 2: Barriereschicht der Quantenstruktur
- 3: Emitterschicht der Quantenstruktur
- 23: Quantenstruktur-Emitter
- 4: hochdotierte Schicht
- 5: strahlungsdurchlässige leitfähige Schicht
- 6: elektrische Kontaktstruktur
- 7: erste Halbleiterschicht der zweiten Diode
- 8: zweite Halbleiterschicht der zweiten Diode
- 9: Kontaktschicht

## Patentansprüche

1. Halbleiter-Bauelement, das eine Solarzelle ist, mit einem Quantenstruktur-Emitter (23),
wobei der Quantenstruktur-Emitter (23) aus einer ersten Schicht (2) aus einem undotierten Halbleitermaterial mit großem Bandabstand, aus einer zweiten, mittleren, hoch dotierten Schicht (3) aus einem Halbleitermaterial mit niedrigem Bandabstand und aus einer dritten, undotierten Schicht (2) aus einem Halbleitermaterial mit großem Bandabstand besteht, sodass der Bandabstand der ersten und dritten Schicht (2) je bei mindestens 1,5 eV liegt und der Bandabstand der zweiten Schicht (3) bei höchstens 0,9 eV liegt und eine Dotierstoffkonzentration der zweiten Schicht (3) bei mindestens 5 × 10¹⁸ 1/cm³ liegt, wobei der Quantenstruktur-Emitter (23) zumindest einen Teil einer ersten Diode (1, 23, 4) bildet und an dieser ersten Diode eine zweite Diode (7, 8, 9) aus anderen Halbleitermaterialien mit größerem Bandabstand angebracht ist,
wobei die erste und dritte Schicht (2) des Quantenstruktur-Emitters (23) je aus SiGeC sind, und die zweite Schicht (3) aus Si, Ge oder SiGe ist.

2. Halbleiter-Bauelement nach dem vorhergehenden Anspruch, bei dem sich die erste (2), die zweite (3) und die dritte Schicht (2) flächig und zusammenhängend über den Quantenstruktur-Emitter (23) erstrecken.

3. Halbleiter-Bauelement nach einem der vorhergehenden Ansprüche,
bei dem die Schichten (2, 3) des Quantenstruktur-Emitters (23) jeweils die Tunnelbedingungen erfüllen.

4. Halbleiter-Bauelement nach dem vorhergehenden Anspruch, bei dem eine Gesamtdicke des Quantenstruktur-Emitters (23) bei höchstens 10 nm liegt, sodass der Quantenstruktur-Emitter (23) insgesamt die Tunnelbedingungen erfüllt.

5. Halbleiter-Bauelement nach einem der vorhergehenden Ansprüche,
bei dem die zweite Schicht (3) bis zur Entartung dotiert ist.

6. Halbleiter-Bauelement nach einem der vorhergehenden Ansprüche,
bei dem die Schichten (2, 3) des Quantenstruktur-Emitters (23) und/oder Schichten der zweiten Diode (7, 8, 9) einkristallin, polykristallin oder amorph abgeschieden sind.

7. Halbleiter-Bauelement nach einem der vorhergehenden Ansprüche,
bei dem zumindest die Schichten (2, 3) des Quantenstruktur-Emitters (23) mittels CVD, PECVD, ALD oder MBE hergestellt sind.

## Claims

1. A semiconductor component, which is a solar cell, comprising a quantum structure emitter (23),
wherein the quantum structure emitter (23) consists of a first layer (2) made of an undoped semiconductor material with a large band gap, a second, middle, highly doped layer (3) made of a semiconductor material with a low band gap, and a third, undoped layer (2) made of a semiconductor material with a large band gap, so that the band gap of the first and third layers (2) is in each case at least 1.5 eV and so that the band gap of the second layer (3) is at most 0.9 eV, and a dopant concentration of the second layer (3) is at least 5 × 10¹⁸ 1/cm³,
wherein the quantum structure emitter (23) forms at least a part of a first diode (1, 23, 4), and a second diode (7, 8, 9) made of other semiconductor materials with a larger band gap is attached to the first diode (1, 23, 4),
wherein the first and third layers (2) are composed in each case of SiGeC, and the second layer (3) is composed of Si, Ge or SiGe.

2. The semiconductor component according to the preceding claim,
wherein the first (2), second (3) and third (2) layer extend in a planar and/or contiguous manner across the quantum structure emitter (23).

3. The semiconductor component according to one of the preceding claims,
wherein the layers (2, 3) of the quantum structure emitter (23) each fulfill tunnel conditions.

4. The semiconductor component according to the preceding claim,
wherein a total thickness of the quantum structure emitter (23) is at most 10 nm, such that the quantum structure emitter (23) overall meets the tunnel conditions.

5. The semiconductor component according to one of the preceding claims,
wherein the second layer (3) is doped until degenerate.

6. The semiconductor component according to one of the preceding claims,
wherein the layers (2, 3) of the quantum structure emitter (23) and/or layers of the second diode (7, 8, 9) are monocrystalline, polycrystalline or amorphous.

7. The semiconductor component according to one of the preceding claims,
wherein at least the layers (2, 3) of the quantum structure emitter (23) are produced by means of CVD, PECVD, ALD or MBE.

## Revendications

1. Un composant semi-conducteur, qui est une cellule solaire, comprenant un émetteur à structure quantique (23),
dans lequel l'émetteur à structure quantique (23) étant constitué d'une première couche (2) constituée d'un matériau semi-conducteur non dopé ayant une large bande interdite, d'une deuxième couche intermédiaire fortement dopée (3) constituée d'un matériau semi-conducteur ayant une bande interdite basse, et d'une troisième couche non dopée (2) constituée d'un matériau semi-conducteur ayant une large bande interdite, de telle sorte que la bande interdite des première et troisième couches (2) est dans chaque cas d'au moins 1,5 eV et de telle sorte que la bande interdite de la deuxième couche (3) est d'au plus 0,9 eV, et une concentration de dopant de la deuxième couche (3) est d'au moins 5 × 10¹⁸ 1/cm³,
dans lequel l'émetteur de structure quantique (23) forme au moins une partie d'une première diode (1, 23, 4), et une seconde diode (7, 8, 9) constituée d'autres matériaux semiconducteurs ayant une bande interdite plus grande est fixée à la première diode (1, 23, 4),
dans lequel les première et troisième couches (2) étant composées respectivement de SiGeC, et la deuxième couche (3) étant composée de Si, Ge ou SiGe.

2. Le composant semi-conducteur selon la revendication précédente,
dans lequel la première (2), la deuxième (3) et la troisième (2) couche s'étendant de manière plane et/ou contiguë à travers l'émetteur à structure quantique (23).

3. Le composant semi-conducteur selon l'une des revendications précédentes,
dans lequel les couches (2, 3) de l'émetteur à structure quantique (23) satisfaisant chacune des conditions de tunnel.

4. Le composant semi-conducteur selon la revendication précédente,
dans lequel une épaisseur totale de l'émetteur à structure quantique (23) étant d'au plus 10 nm, de telle sorte que l'émetteur à structure quantique (23) satisfait globalement les conditions de tunnel.

5. Le composant semi-conducteur selon l'une des revendications précédentes,
dans lequel la seconde couche (3) étant dopée jusqu'à ce qu'elle soit dégénérée.

6. Le composant semi-conducteur selon l'une des revendications précédentes,
dans lequel les couches (2, 3) de l'émetteur à structure quantique (23) et/ou des couches de la deuxième diode (7, 8, 9) étant monocristallines, polycristallines ou amorphes.

7. Le composant semi-conducteur selon l'une des revendications précédentes,
dans lequel au moins les couches (2, 3) de l'émetteur à structure quantique (23) étant produites par CVD, PECVD, ALD ou MBE.
